# EUROPÄISCHE PATENTSCHRIFT

(11) **EP 2 681 800 B1**
(45) Veröffentlichungstag und Bekanntmachung des Hinweises auf die Patenterteilung: **27.09.2017**
(21) Anmeldenummer: 12702516.1
(22) Anmeldetag: 02.02.2012
(51) Int. Cl.: H01Q 1/38, H01Q 9/04, H01Q 21/06

(54) **LEITERPLATTENANORDNUNG FÜR MILLIMETERWELLEN-SCANNER**
PRINTED CIRCUIT BOARD ARRANGEMENT FOR MILLIMETER WAVE SCANNERS
ENSEMBLE DE CIRCUIT IMPRIMÉ POUR SCANNER À ONDES MILLIMÉTRIQUES

(30) Priorität: 04.03.2011 DE 102011005145
(43) Veröffentlichungstag der Anmeldung: 08.01.2014
(73) Patentinhaber: Rohde & Schwarz GmbH & Co. KG, 81671 München (DE)
(72) Erfinder: JÜNEMANN, Ralf, 81735 München (DE); EVERS, Christian, 85551 Kirchheim (DE); SCHIESSL, Andreas, 81671 München (DE); AHMED, Sherif, 81737 München (DE); HECHTFISCHER, Gerd, 85591 Vaterstetten (DE)
(74) Vertreter: Körfer, Thomas
(86) Internationale Anmeldenummer: PCT/EP2012/051737
(87) Internationale Veröffentlichungsnummer: WO 2012/119818

(56) Entgegenhaltungen:
- EP-A1- 1 280 392
- EP-A1- 2 144 329
- WO-A1-99/59221
- GB-A- 2 194 101
- JP-A- 2002 043 832
- US-A1- 2008 191 956
- US-A1- 2009 066 590
- US-A1- 2009 109 109
- US-A1- 2009 207 090
- US-B1- 6 195 049

## Beschreibung

Die Erfindung betrifft eine Leiterplattenanordnung mit zumindest einer teilweise integrierten Sende- und/oder Empfangseinheit und zumindest einem Antennenelement, welches bevorzugt im Frequenzbereich für Millimeterwellen arbeitet.

Leiterplattenanordnungen die in dem genannten Umfeld eingesetzt werden, dienen dazu, verschiedene Sende- und/oder Empfangseinheiten mit den entsprechenden Antennenelementen elektrisch zu kontaktieren, wobei gleichzeitig die Stromversorgung der entsprechenden Sende- und/oder Empfangseinheiten sichergestellt sein soll. Dabei sollen die Leiterplattenanordnungen derart beschaffen sein, dass das Gesamtsystem möglichst kompakt aufgebaut werden kann und die ungewünschte Emission von Störstrahlung auf ein Minimum reduziert wird, wobei gleichzeitig die Störfestigkeit der gesamten Anordnung gegenüber elektromagnetischen Wellen sichergestellt sein muss.

Aus der WO99/59221 ist eine Leiterplattenanordnung mit einer integrierten Signalverarbeitungseinheit und einer integrierten Patchantenne bekannt, bei der die Patchantenne durch eine Anzahl von Durchkontaktierungen in der Leiterplattenanordnung abgeschirmt wird. Aus der EP 2 144 329 A1 ist eine Leiterplattenanordnung mit zumindest mehreren Antennenelementen und einer Sende- und/oder Empfangseinheit bekannt. Jedes Antennenelement ist dabei als Patch-Antenne aufgebaut, die über einen Schlitz mit darunterliegender Zuführung angeregt werden kann. Das Antennensystem arbeitet im Millimeterwellenbereich.

Nachteilig an der EP 2 144 329 A1 ist, dass die Leiterplattenanordnung ausschließlich aus Substraten besteht, die sich für höchste Frequenzen eignen, wodurch der Aufbau der Leiterplattenanordnung kostspielig ist.

Es ist daher die Aufgabe der Erfindung eine Leiterplattenanordnung und einen zugehörigen Millimeterwellen-Scanner zu schaffen, die bzw. der sich kostengünstiger herstellen lässt.

Die Aufgabe wird bezüglich der Leiterplattenanordnung durch die Merkmale des Anspruchs 1 und bezüglich des Millimeterwellen-Scanners durch die Merkmale des Anspruchs 15 gelöst. In den jeweiligen Unteransprüchen sind vorteilhafte Weiterbildungen der erfindungsgemäßen Leiterplattenanordnung angegeben.

Erfindungsgemäß wird der hochfrequente Teil von dem niederfrequenten Teil und dem Gleichstromteil getrennt, sodass eine Beeinflussung der verschiedenen Teile möglichst reduziert wird, um dadurch die Messgenauigkeit zu erhöhen. Gleichzeitig sollen innerhalb der Leiterplattenanordnung nur für den hochfrequenten Teil Substrate verwendet werden, die für hohe Frequenzen ausgelegt sind, wohingegen für den niederfrequenten Teil oder den Gleichstromteil Substrate verwendet werden sollen, deren dielektrische Eigenschaften für diesen Bereich ausreichend sind, um dadurch die Herstellungskosten zu reduzieren.

Die erfindungsgemäße Leiterplattenanordnung dient zum elektrischen Verbinden zumindest einer Sende- und/oder Empfangseinheit mit zumindest einem Antennenelement, wobei die zumindest eine Sende- und/oder Empfangseinheit und das zumindest eine Antennenelement zumindest teilweise in die Leiterplattenanordnung integriert sind. Die Leiterplattenanordnung besteht dabei aus verschiedenen Leiterplatten, die mechanisch fest miteinander verbunden sind, wobei ein erster Teil der Leiterplattenanordnung durch zumindest eine Leiterplatte gebildet ist, deren Substrat aus einem ersten Material besteht, das für Hochfrequenz geeignet ist, und ein zweiter Teil der Leiterplattenanordnung durch zumindest eine Leiterplatte gebildet ist, deren Substrat aus einem gegenüber dem ersten Material unterschiedlichen zweiten Material besteht, welches für eine Niederfrequenz und/oder für einen Gleichspannungsbereich noch ausreichend geeignet ist.

Besonders vorteilhaft ist es, wenn die erfindungsgemäße Leiterplattenanordnung aus verschiedenen Leiterplatten besteht, wobei das Material des Substrats des ersten Teils der Leiterplattenanordnung für Hochfrequenz geeignet ist und das Material des Substrats des zweiten Teils der Leiterplattenanordnung für eine Niederfrequenz und/oder einen Gleichspannungsbereich noch ausreichend geeignet ist und sich beide Materialen unterscheiden. Durch Wahl von unterschiedlichen Substraten, wobei Substrate für einen Niederfrequenz-Bereich und/oder für einen Gleichspannungsbereich deutlich günstiger sind, als jene, die sich für Anwendungen mit hohen Frequenzen eigenen, kann die Leiterplattenanordnung letztlich deutlich günstiger gefertigt werden.

Weiterhin besteht bei der erfindungsgemäßen Leiterplattenanordnung ein Vorteil, wenn beide Teile der Leiterplattenanordnung durch eine Massefläche voneinander getrennt sind. Dadurch wird vermieden, dass hochfrequente Signalanteile in den niederfrequenten Bereich und/oder in den Gleichspannungsbereich einkoppeln und dabei Messsignale verfälscht werden.

Zusätzlich besteht ein Vorteil bei der erfindungsgemäßen Leiterplattenanordnung, wenn das zumindest eine Antennenelement und die zumindest eine Sende- und/oder Empfangseinheit in dem ersten Teil der Leiterplattenanordnung ausgebildet sind. Dadurch ist sichergestellt, dass die hochfrequenten Signalanteile nicht in den Teil einkoppeln, der für die niederfrequenten Signalanteil vorgesehen ist und sich z.B. dem Messsignal als Störimpuls überlagern können.

Ein weiterer Vorteil der erfindungsgemäßen Leiterplattenanordnung besteht, wenn der Sende- und/oder Empfangschip direkt auf der Massefläche angeordnet ist, weil dadurch eine effektive Wärmeabfuhr gewährleistet ist.

Außerdem besteht für die erfindungsgemäße Leiterplattenanordnung ein Vorteil, wenn über dem zumindest einen Antennenelement weiterhin ein Hornelement angeordnet ist, das in einen elektrisch leitfähigen Deckel gebohrt und/oder gefräst und/oder geätzt ist und wenn dieser elektrisch leitfähige Deckel fest mit der Leiterplattenanordnung verschraubt und/oder verklebt ist. Ein solches Hornelement erhöht dabei die Richtwirkung des zumindest einen Antennenelements, wodurch die Leistungsaufnahme verringert werden kann. Indem das Hornelement in einen leitfähigen Deckel integriert ist, ist sichergestellt, dass eine unerwünschte Emission des hochfrequenten Signals vermieden wird und dass in die Leiterplattenanordnung kein hochfrequentes Signal einkoppeln kann.

Weiterhin besteht bei der erfindungsgemäßen Leiterplattenanordnung ein Vorteil, wenn mit Ausnahme der Ausnehmung für das Hornelement eine Oberseite des elektrisch leitfähigen Deckels mit einer Dämpfungsmatte bedeckt ist und/oder wenn eine Unterseite oberhalb des Hohlraums des ersten Teils der Leiterplattenanordnung mit einer Dämpfungsmatte bedeckt ist, weil durch die Dämpfungsmatte die Amplitude von auftretenden Stehwellen und/oder Resonanzen verringert wird, was zu einer Erhöhung der Messgenauigkeit führt.

Außerdem besteht bei der erfindungsgemäßen Leiterplattenanordnung ein Vorteil, wenn mehrere Durchkontaktierungen radial um die Patchantenne herum angeordnet sind und den ersten Teil der Leiterplattenanordnung bis zu der Massefläche durchdringen. Dadurch ist sichergestellt, dass sich keine elektromagnetischen Wellen innerhalb der Leiterplattenanordnung ausbreiten, die gegebenenfalls in benachbarte Antennenelemente und/oder Sende- und/oder Empfangseinheiten einkoppeln können.

Weiterhin ist es besonders vorteilhaft, wenn die Sende- und/oder Empfangseinheit mit mehreren Antennenelementen verbunden ist und wenn eine Vielzahl von Antennenelementen auf der Leiterplattenanordnung in einem Quadrat angeordnet sind. Durch eine Vielzahl von derartigen Antennenelementen wird erreicht, dass eine ausreichend gute räumliche Auflösung erzielt wird.

Schlussendlich ist es bei der erfindungsgemäßen Leiterplattenanordnung vorteilhaft, dass mehrere Leiterplattenanordnungen mit zumindest je einem Antennenelement zusammen als Array agieren, wobei von genau einem Antennenelement des gesamten Arrays ein Signal aussendbar ist und wobei für alle anderen Antennenelemente des gesamten Arrays, die mit einer Empfangseinheit verbunden sind, eine Reflektion dieses Signals empfangbar ist. Durch eine derartige Erweiterung einer einzelnen Leiterplattenanordnung hin zu einem System mit mehreren Leiterplattenanordnungen kann auf eine sehr einfache und kostengünstige Art und Weise der abtastbare Bereich vergrößert werden, bzw. die Auflösung mit der ein Bereich abgetastet wird, erhöht werden.

Verschiedene Ausführungsbeispiele der Erfindung werden nachfolgend unter Bezugnahme auf die Zeichnung beispielhaft beschrieben. Gleiche Gegenstände weisen dieselben Bezugszeichen auf. Die entsprechenden Figuren der Zeichnung zeigen im Einzelnen:
- Fig. 1: ein vereinfachtes Blockschaltbild eines Ausführungsbeispiels zum Betreiben eines Millimeterwellen-Scanners, das die in die erfindungsgemäße Leiterplattenanordnung integrierte Sende- und/oder Empfangseinheit und das zumindest ein Antennenelement beinhaltet;
- Fig. 2: ein Ausführungsbeispiel eines Schnitts durch die erfindungsgemäße Leiterplattenanordnung;
- Fig. 3: ein Ausführungsbeispiel eines Schnitts durch die erfindungsgemäße Leiterplattenanordnung, die das zumindest eine Antennenelement, die Sende- und/oder Empfangseinheit und einen Deckel beinhaltet;
- Fig. 4: ein Ausführungsbeispiel einer Draufsicht auf die erfindungsgemäße Leiterplattenanordnung mit einem Deckel und einem Antennenelement;
- Fig. 5: ein Ausführungsbeispiel einer Draufsicht auf die erfindungsgemäße Leiterplattenanordnung mit einem abgenommenen Deckel, einem Antennenelement und einer Sende- und/oder Empfangseinheit;
- Fig. 6: ein Ausführungsbeispiel einer Draufsicht auf die Unterseite einer ersten Leiterplatte innerhalb des ersten Teils der erfindungsgemäßen Leiterplattenanordnung;
- Fig. 7: ein Ausführungsbeispiel einer Draufsicht auf die Oberseite einer zweiten Leiterplatte innerhalb des ersten Teils der erfindungsgemäßen Leiterplattenanordnung; und
- Fig. 8: ein Ausführungsbeispiel einer Draufsicht auf die erfindungsgemäße Leiterplattenanordnung mit einem Deckel und einer Vielzahl an Antennenelementen.

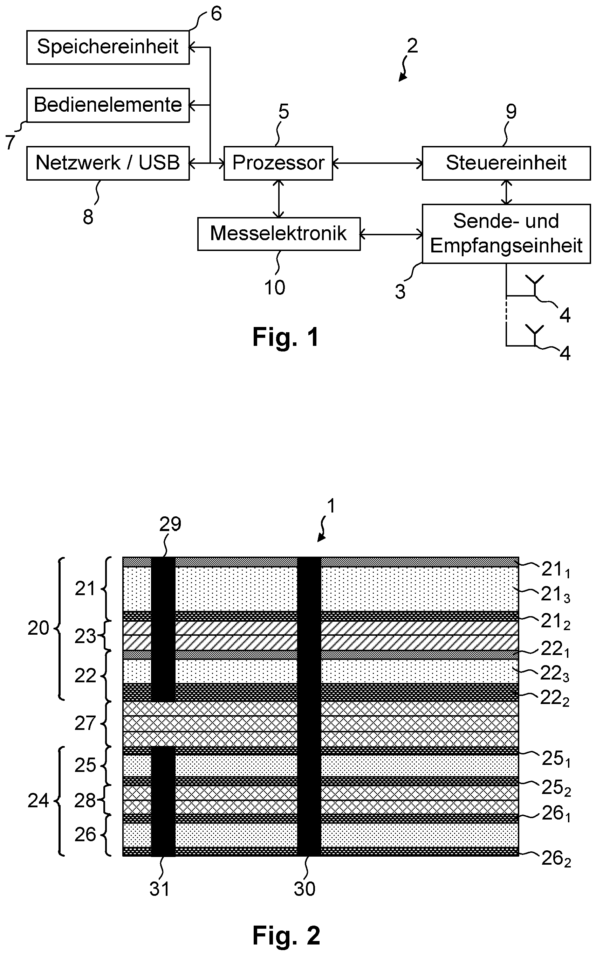

Fig. 1 zeigt ein vereinfachtes Blockschaltbild eines Ausführungsbeispiels zum Betreiben eines Millimeterwellen-Scanners 2, das die zumindest eine, in die erfindungsgemäße Leiterplattenanordnung 1 integrierte Sende- und/oder Empfangseinheit 3 und das zumindest eine Antennenelement 4 beinhaltet. Der Millimeterwellen-Scanner 2 umfasst eine zentrale Datenverarbeitungseinheit 5, die in Form eines Prozessors und/oder eines FPGAs (engl. field programmable gate array; dt. im (Anwendungs-)Feld programmierbare (Logik-)Gatter-Anordnung) und/oder eines digitalen Signalprozessors ausgebildet ist. Mit der zentralen Datenverarbeitungseinheit 5 ist zumindest eine Speichereinheit 6 verbunden, in der beispielsweise die Messdaten sowie das Betriebssystem und die Anwendungssoftware abgelegt sind. Mit der zentralen Datenverarbeitungseinheit 5 sind weiterhin Bedienelemente 7, wie z.B. eine Tastatur und/oder Knöpfe, bzw. Taster, sowie diverse Schnittstellen 8, wie beispielsweise Netzwerkverbindungen und/oder USB-Verbindungen (engl. universal serial bus; dt. universeller serieller Bus) verbunden.

Außerdem ist die zentrale Datenverarbeitungseinheit 5 noch mit einer Steuereinheit 9 und der Messelektronik 10 verbunden. Die Steuereinheit 9 und die Messelektronik 10 sind dabei wiederum mit der Sende- und/oder Empfangseinheit 3 verbunden. Die Steuereinheit 9 kann die Sende- und/oder Empfangseinheit 3 steuern, und diese z.B. ein-, bzw. ausschalten. Weiterhin kann die Steuereinheit 9 auch festzulegen, welches Antennenelement 4 von der Sende- und/oder Empfangseinheit 3 angesteuert wird. Die Messelektronik 10 beinhaltet sämtliche Mittel, um die notwendigen HF-Signale (engl. radio frequency; dt. Hochfrequenz) zu erzeugen und um ein von einer Empfangseinheit 3 empfangenes ZF-Signal (Zwischenfrequenz) auszuwerten. Die Sende- und/oder Empfangseinheit 3 ist dabei mit einem oder mehreren Antennenelementen 4 verbunden. Ein Millimeterwellen-Scanner 2 kann mehr als eine Sende- und/oder Empfangseinheit 3 beinhalten, die wiederum mit der Steuereinheit 9 und der Messelektronik 10 verbunden sind. Bei allen Verbindungen handelt es sich im Übrigen um elektrisch leitfähige Verbindungen über die Datenpakete oder analoge Messsignale übertragen werden können.

Der Millimeterwellen-Scanner 2 arbeitet bevorzugt in einem Frequenzbereich bei 80 GHz. Derartige Frequenzen werden bevorzugt nicht direkt in der Messelektronik 10 erzeugt, sondern in der Sende- und/oder Empfangseinheit 3 mittels zumindest einer integrierten Mischerstufe. Dabei stellt die Messelektronik 10 bevorzugt ein Signal mit einer Frequenz von ungefähr 20 GHz zur Verfügung, welches innerhalb der Sende- und/oder Empfangseinheit 3 vervierfacht wird. Der Millimeterwellen-Scanner 2 kann beispielsweise dazu verwendet werden, um Personen oder Waren genauer zu analysieren.

Im Weiteren wird auf die Problematik eingegangen, wie das auf einen Frequenzbereich bei 80 GHz vervierfachte Signal von der Sende- und/oder Empfangseinheit 3 zu den Antennenelementen 4 mit möglichst kostengünstigen Mitteln effizient übertragen werden kann.

Fig. 2 zeigt hierfür ein Ausführungsbeispiel eines Schnitts durch die erfindungsgemäße Leiterplattenanordnung 1. In dem Ausführungsbeispiel aus Fig. 2 besteht die erfindungsgemäße Leiterplattenanordnung 1 aus zwei Teilen. Ein erster Teil 20 besteht in dem Ausführungsbeispiel aus zwei einzelnen Leiterplatten 21 und 22. Die beiden Leiterplatten 21 und 22 beinhalten ein Substrat 21₃, 22₃, welches für hohe Frequenzen prinzipiell geeignet ist. Für Frequenzen im Millimeterwellen-Bereich werden normalerweise Keramiken als Substratmaterial eingesetzt, weil auf diesen die Leiterbahnen mit höherer Genauigkeit prozessiert werden können. Allerdings erlaubt der erfindungsgemäße Aufbau der Leiterplattenanordnung 1, wie im Folgenden noch erläutert wird, auch den Einsatz von anderen Substratmaterialien, die für hohe Frequenzen geeignet sind, um den Millimeterwellen-Scanner 2 zu betreiben. Für das hochfrequenztaugliche Substrat 21₃, 22₃ der einzelnen Leiterplatten 21 und 22 des ersten Teils 20 der Leiterplattenanordnung 1 kommt beispielsweise das Substrat 4350B von Rogers zum Einsatz. Die dielektrischen Eigenschaften dieses Substrats sind für Hochfrequenzanwendungen günstig.

Eine obere Schicht 21₁ der Leiterplatte 21 besteht bevorzugt aus teilvergoldetem Kupfer. Dieses teilvergoldete Kupfer hat den Vorteil, dass die hochfrequenten elektromagnetischen Wellen weniger stark gedämpft werden und dass diese Schicht mit Bonddrähten verbindbar ist. Eine untere Schicht 21₂ der Leiterplatte 21 des ersten Teils 20 der Leiterplattenanordnung 1 besteht dagegen aus normalem Kupfer. Die Schichtdicken liegen hierbei im üblichen Rahmen.

Die zweite Leiterplatte 22 des ersten Teils 20 der Leiterplattenanordnung 1 besteht in ihrer oberen Schicht 22₁ bevorzugt ebenfalls aus teilvergoldetem Kupfer. Die untere Schicht 22₂ der Leiterplatte 22 besteht aus einer normalen Kupferschicht, wobei die Kupferschicht, verglichen mit den anderen Kupferschichten, sehr dick ist. Untersuchungen habe ergeben, dass eine Kupferschicht von beispielsweise mehr als ca. 100 µm bezüglich des Wärmetransports hervorragende Ergebnisse liefert. Bei dieser Schicht handelt es sich auch um die Massefläche 22₂, die wie später noch erläutert, den Hochfrequenzbereich von dem Niederfrequenzbereich bzw. dem Gleichspannungsbereich trennt.

Die beiden Leiterplatten 21 und 22 des ersten Teils 20 der Leiterplattenanordnung 1 werden über eine Klebeschicht 23 mechanisch fest miteinander verbunden. Diese Verbindung wird dadurch verstärkt, dass die beiden Leiterplatten 21 und 22 zusätzlich miteinander verpresst werden. Diese Klebeschicht 23 muss ebenfalls günstiges Verhalten für hochfrequente elektromagnetische Wellen zeigen. Beispielsweise kann für diese Schicht das Material 4450B von Rogers eingesetzt werden.

Neben diesem ersten Teil 20 der Leiterplattenanordnung 1, dessen Substrate 21₃, 22₃ aus einem Material bestehen, das hochfrequente elektromagnetische Wellen weniger stark dämpft, werden für den zweiten Teil 24 der Leiterplattenanordnung 1 Leiterplatten 25 und 26 verwendet, die sich einzig für niedrige Frequenzen und Gleichspannungen eignen und für hohe Frequenzen nicht eingesetzt werden können. In dem Ausführungsbeispiel aus Fig. 2 besteht der zweite Teil 24 der Leiterplattenanordnung 1 genauso wie der erste Teil 20 der Leiterplattenanordnung 1 aus zwei Leiterplatten 25 und 26. Beide Leiterplatten 25 und 26 sind identisch aufgebaut. Sowohl die obere Schicht 25₁ der Leiterplatte 25 als auch die obere Schicht 26₁ der Leiterplatte 26 bestehen, wie auch die untere Schicht 25₂ der Leiterplatte 25 und die untere Schicht 26₂ der Leiterplatte 26, aus Kupfer, mit einer üblichen Dicke. Bei den Leiterplatten 25 und 26 kann beispielsweise das günstige FR4-Material verwendet werden. Diese Materialien, bzw. Substrate sind für hohe Frequenzen nicht geeignet, weil die dielektrischen Verluste diese zu stark bedämpfen würden.

Zwischen der zweiten Leiterplatte 22 des ersten Teils 20 und der ersten Leiterplatte 25 des zweiten Teils 24 der Leiterplattenanordnung 1 befindet sich eine Zwischenschicht 27. Eine solche Zwischenschicht 28 befindet sich ebenfalls zwischen der ersten Leiterplatte 25 und der zweiten Leiterplatte 26 des zweiten Teils 24 der Leiterplattenanordnung 1. Beide Zwischenschichten 27, 28 können beispielsweise aus Prepeg (engl. preimpregnated fibers; dt. vorimprägnierte Fasern) bestehen. Diese Zwischenschichten 27, 28 eignen sich ebenfalls nicht für hohe Frequenzen. Das in Fig. 2 dargestellte Schichtsystem der erfindungsgemäßen Leiterplattenanordnung 1 ist dabei auf eine Dicke von wenigen Millimetern verpresst.

Exemplarisch eingezeichnet sind in Fig. 2 auch noch verschiedenen Durchkontaktierungen. Eine erste Durchkontaktierung 29 verbindet die erste Leiterplatte 21 mit der zweiten Leiterplatte 22 des ersten Teils 20 der Leiterplattenanordnung 1. Eine weitere Durchkontaktierung 30 verbindet den ersten Teil 20 mit dem zweiten Teil 24 der Leiterplattenanordnung 1. Es ist ebenfalls eine Durchkontaktierung 31 vorhanden, die einzig die Leiterplatten 25 und 26 des zweiten Teils 24 der Leiterplattenanordnung 1 miteinander verbindet. Außerdem können auch Durchkontaktierungen eingesetzt werden, die nicht bis an die Oberfläche reichen (engl. buried vias). Jedoch sollte darauf geachtet werden, dass möglichst wenig Durchkontaktierungen den ersten Teil 20 der Leiterplattenanordnung 1 mit dem zweiten Teil 24 der Leiterplattenanordnung 1 verbinden, weil dadurch die abschirmende Wirkung der dicken Massefläche 22₂ der Leiterplatte 22 des ersten Teils 20 der Leiterplattenanordnung 1 vermindert wird.

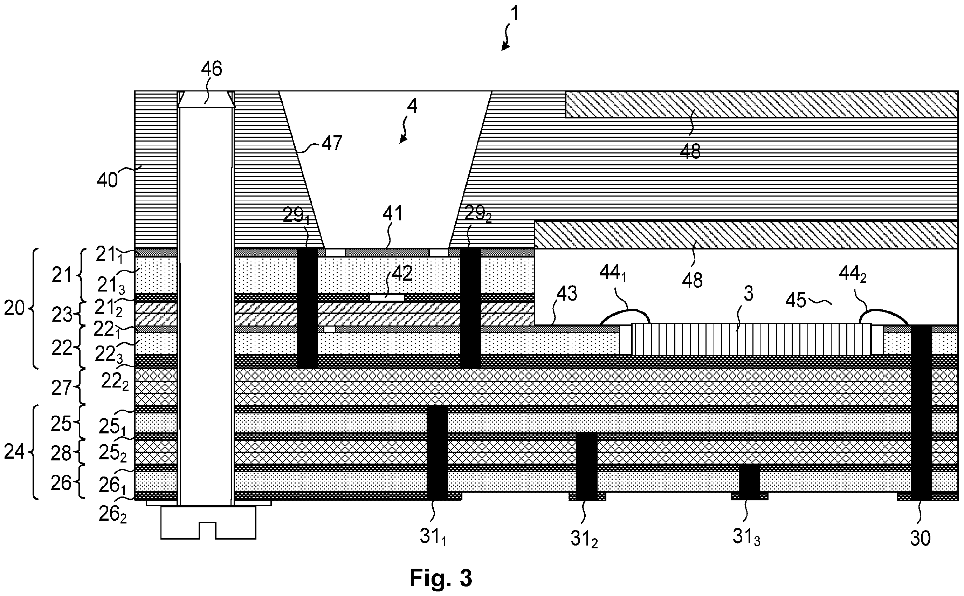

Fig. 3 zeigt ein Ausführungsbeispiel eines Schnitts durch die erfindungsgemäße Leitplattenanordnung 1, die das zumindest eine Antennenelement 4, die Sende- und/oder Empfangseinheit 3 und einen Deckel 40 beinhaltet. Der grundlegende Aufbau der Leiterplattenanordnung 1 aus Fig. 3 entspricht im Wesentlichen dem Aufbau der Leiterplattenanordnung 1 aus Fig. 2. Auch in Fig. 3 besteht die Leiterplattenanordnung 1 aus einem ersten Teil 20 und einem zweiten Teil 24, wobei jeder Teil 20, 24 ebenfalls je zwei Leiterplatten 21, 22 und 25, 26 aufweist. Auch in Fig. 3 sind die Leiterplatten 21, 22 des ersten Teils 20 für hohe Frequenzen geeignet, wohingegen die Leiterplatten 25, 26 des zweiten Teils 24 für niedrige Frequenzen, nicht aber für hohe Frequenzen geeignet sind.

Durch Verkleben und/oder Verpressen dieser unterschiedlichen Leiterplatten 21, 22 und 25, 26 wird die erfindungsgemäße Leiterplattenanordnung 1 hergestellt, wobei durch Verwenden der unterschiedlichen Materialen innerhalb der Substrate die Herstellung der Leiterplattenanordnung 1 sehr günstig erfolgt.

Die Leiterplattenanordnung 1 aus Fig. 3 umfasst in diesem Ausführungsbeispiel zusätzlich zumindest ein Antennenelement 4 und zumindest eine Sende- und/oder Empfangseinheit 3, die als Sende- und/oder Empfangschip 3 ausgebildet ist. Sowohl das zumindest eine Antennenelement 4 als auch die zumindest eine Sende- und/oder Empfangseinheit 3 sind dabei in dem ersten Teil 20 der Leiterplattenanordnung 1 ausgebildet.

Bei dem zumindest einen Antennenelement 4 handelt es sich bevorzugt um eine angeregte Patchantenne 41. Die Patchantenne 41 ist dabei in die obere Schicht 21₁ der ersten Leiterplatte 21 des ersten Teils 20 der Leiterplattenanordnung 1 integriert. Dies erfolgt bevorzugt durch einen Ätzprozess oder einen Fräsprozess. Die Patchantenne 41 ist ungefähr so dimensioniert, dass er im gewünschten Frequenzbereich des Millimeterwellen-Scanners 2 resonant ist. Die Patchantenne 41 besteht, wie bereits erläutert, bevorzugt aus teilvergoldetem Kupfer. In der unteren Schicht 21₂ der ersten Leiterplatte 21 des ersten Teils 20 der Leiterplattenanordnung 1 ist zumindest ein Schlitz 42 ausgebildet. Die Patchantenne 41 wird über den Schlitz 42 bevorzugt von einer koplanaren Zweibandleitung 43 angeregt. Diese koplanare Zweibandleitung 43 ist an ihrem Ende, wie später noch erläutert wird, in einen Dipol überführt. Die koplanare Zweibandleitung 43 ist durch einen Ätzprozess oder Fräsprozess in die obere Schicht 22₁ der zweiten Leiterplatte 22 des ersten Teils 20 der Leiterplattenanordnung 1 integriert. Neben einer koplanaren Zweibandleitung 43 können auch andere Leistungstypen dazu verwendet werden, um die Patch-Antenne 41 anzuregen.

Die koplanare Zweibandleitung 43, die in der oberen Schicht 22₁ der zweiten Leiterplatte 22, die ebenfalls aus teilvergoldetem Kupfer besteht, integriert ist, ist über Bonddrähte 44₁ mit der Sende- und/oder Empfangseinheit 3 elektrisch verbunden. Über zumindest einen weiteren Bonddraht 44₂ ist die Sende- und/oder Empfangseinheit 3 mit weiteren Leiterbahnen auf der oberen Schicht 22₁ der Leiterplatte 22 des ersten Teils 20 der Leiterplattenanordnung 1 elektrisch verbunden. Über diesen zumindest einen Bonddraht 44₂ und die Durchkontaktierung 30 kann eine Verbindung von der Sende- und/oder Empfangseinheit 3 mit dem zweiten Teil 24 und dort mit den Leiterplatten 25, bzw. 26 der Leiterplattenanordnung 1 hergestellt werden.

Gut zu erkennen ist weiterhin, dass in die Leiterplattenanordnung 1 ein Hohlraum 45 gefräst oder eingestanzt ist. Dieser Hohlraum 45 ist bevorzugt T-förmig ausgebildet. Innerhalb dieses T-förmigen Hohlraums 45 sind die Leiterplatte 21 und die Klebeverbindung 23 vollständig entfernt. Zusätzlich sind in dem Hohlraum 45 die obere Schicht 22₁ und das Substrat 22₃ der zweiten Leiterplatte 22 des ersten Teils 20 der Leiterplattenanordnung 1 auf einer bestimmten Fläche entfernt, wobei die Fläche so groß ist, dass die Sende- und/oder Empfangseinheit 3 problemlos in diese eingeführt werden kann und auf der dicken Massefläche 22₂, die auch die untere Schicht 22₂ der zweiten Leiterplatte 22 darstellt, befestigt, insbesondere verklebt werden kann. Dadurch wird erreicht, dass die Sende- und/oder Empfangseinheit 3, bzw. der Sende- und/oder Empfangschip 3 zur besseren Wärmeabfuhr direkt auf der geschlossenen Massefläche 22₂ angeordnet ist.

Weiterhin kann die Leiterplattenanordnung 1 auch einen Deckel 40 umfassen. Dieser Deckel 40 besteht bevorzugt aus einem massiven elektrisch leitfähigen Material, welches bevorzugt zusätzlich vergoldet ist. Dieser Deckel 40 wird direkt auf die obere Schicht 21₁ der ersten Leiterplatte 21 des ersten Teils 20 der Leiterplattenanordnung 1 gesetzt und mit einer Schraubverbindung 46 mechanisch fest mit dieser verbunden. Durch das Anziehen dieser Schraubverbindung 46 wird ebenfalls sichergestellt, dass die obere Schicht 21₁ elektrisch leitend mit dem Deckel 40 verbunden ist, was weiterhin dadurch erleichtert wird, dass sowohl die obere Schicht 21₁, als auch der Deckel 40 teilvergoldet sind. Der Deckel 40 weist weiterhin eine Ausnehmung in Form einer konischen Figur auf, die im Weiteren als Hornelement 47 bezeichnet wird. Das Hornelement 47 wird in den elektrisch leitfähigen Deckel 40 eingebracht, insbesondere gebohrt bzw. gefräst und/oder geätzt. Wie in Fig. 3 dargestellt ist, ist über dem zumindest einen Antennenelement 4 direkt das Hornelement 47 angeordnet. Dadurch wird erreicht, dass das von der Patchantenne 41 abgestrahlte elektromagnetische Feld einer gewissen Richtcharakterisik unterliegt.

Gut zu erkennen ist auch, dass der elektrisch leitfähige Deckel 40 die gesamte obere Schicht 21₁ des ersten Teils 20 der Leiterplattenanordnung 1 mit Ausnahme des zumindest einen Antennenelements 4 bedeckt. Dadurch ist sichergestellt, dass außerhalb des zumindest einen Antennenelements 4 kein elektromagnetisches Feld abgestrahlt wird und im Gegenzug dazu keine Störstrahlung in die Leiterplattenanordnung 1 von außerhalb einkoppeln kann.

Weiterhin ist gut zu erkennen, dass mit Ausnahme der Ausnehmung für das Hornelement 47 eine Oberseite des elektrisch leitfähigen Deckels mit einer Dämpfungsmatte 48 bevorzugt vollständig bedeckt ist. Dieser Sachverhalt ist der Übersichtlichkeit wegen nicht in Fig. 3 dargestellt. Es ist ebenfalls möglich, dass eine Unterseite des elektrisch leitfähigen Deckels 40, die sich oberhalb des Hohlraums 45 im ersten Teil 20 der Leiterplattenanordnung 1 befindet, ebenfalls mit einer Dämpfungsmatte 48 bedeckt ist. Dadurch wird eine Reduktion der Amplitude von Stehwellen erreicht.

Gut zu erkennen ist ebenfalls, dass das zumindest eine Antennenelement 4 innerhalb einer Art Käfig angeordnet ist. Dieser Käfig besteht zum einen aus dem Durchkontaktierungen 29₁ bis 29ₙ, sowie aus der dicken Massefläche 22₂ bzw. der unteren Schicht 22₂ der zweiten Leiterplatte 22 des ersten Teils 20 der Leiterplattenanordnung 1. Darüber hinaus setzt sich dieser Käfig an dem elektrisch leitfähigen Deckel 40 fort. Wie in weiteren Zeichnungsfiguren noch erläutert wird, dienen die Durchkontaktierungen 29₁ bis 29ₙ dazu, dass sich die elektromagnetische Welle des Antennenelements 4 nicht innerhalb der Leiterplattenstruktur 1 ausbreitet. Die dicke Massenfläche 22₂ dient im Weiteren dazu, dass die von der koplanaren Zweibandleitung 43 abgestrahlte elektromagnetische Welle in Richtung des Schlitzes 42 bzw. in Richtung der Patchantenne 41 reflektiert wird. Gut zu erkennen ist dabei auch, dass auf Grund der dicken Massefläche 22₂ der hochfrequente Teil, der dem ersten Teil 20 der Leiterplattenanordnung 1 zugeordnet werden kann, von dem niederfrequenten Teil, der dem zweiten Teil 24 der Leiterplattenanordnung 1 zugeordnet werden kann, vollständig getrennt wird.

Über die Durchkontaktierungen 31₁, 31₂ und 31₃ werden die verschiedenen Masseschichten 25₁, 25₂, 26₁ und 26₂ der Leiterplatten 25 und 26 in dem zweiten Teil 24 der Leiterplattenanordnung 1 miteinander verbunden. Dagegen ist in Fig. 3 nicht dargestellt, dass auf der Unterseite der zweiten Leiterplatte 26 noch eine Steckverbindung angebracht sein kann, mit der die Leiterplattenanordnung 1 mit einer Steuereinheit 9 oder der Messelektronik 10 verbunden werden kann.

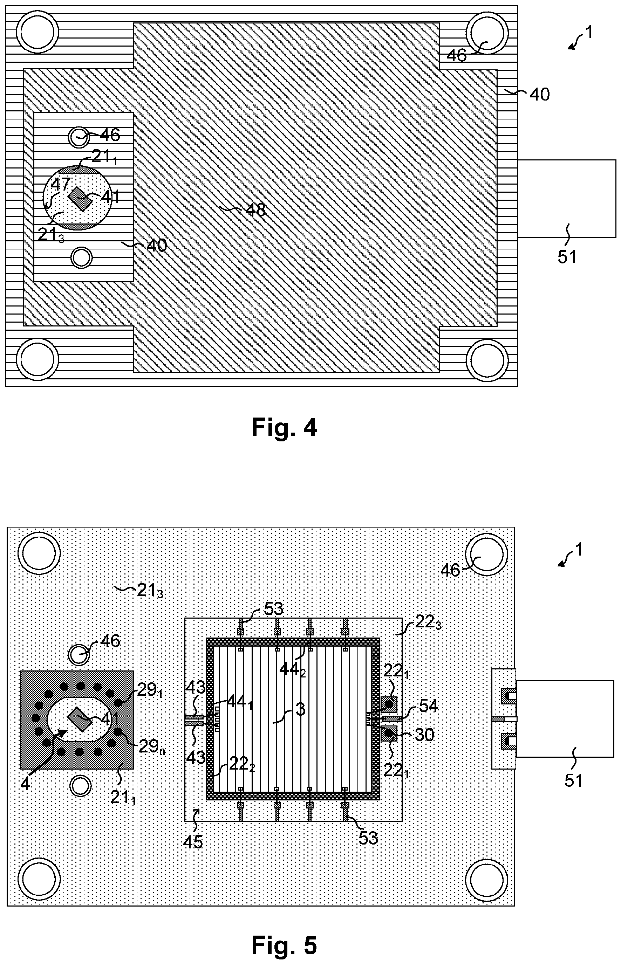

Fig. 4 zeigt ein Ausführungsbeispiel einer Draufsicht auf die erfindungsgemäße Leiterplattenanordnung 1 mit einem Deckel 40 und einem Antennenelement 4. Gut zu erkennen ist die Dämpfungsmatte 48, die aus Gründen der besseren Übersichtlichkeit nicht den gesamten Deckel 40 mit Ausnahme der Ausnehmung für das Hornelement 47 umschließt. Dargestellt sind ebenfalls die Schraubverbindungen 46, über die der Deckel 40 mechanisch fest und elektrisch leitend mit der Leiterplattenanordnung 1 verbunden wird. In der Draufsicht sind ebenfalls die Patchantenne 41 und Teile der oberen Schicht 21₁ der ersten Leiterplatte 21 des ersten Teils 20 der Leiterplattenanordnung 1 zu erkennen. Teile dieser oberen Schicht 21₁ wurden durch einen Ätzprozess oder einen Fräsprozess entfernt, sodass das darunterliegende Substrat 21₃ der Leiterplatte 21 zum Vorschein kommt. Auf der rechten Seite ist beispielsweise noch ein Koaxialstecker 51 sichtbar, über den zum Beispiel das Hochfrequenzsignal der Sende- und/oder Empfangseinheit 3 zugeführt werden kann.

Fig. 5 zeigt ein Ausführungsbeispiel einer Draufsicht auf die erfindungsgemäße Leiterplattenanordnung 1 mit einem abgenommenen Deckel 40, einem Antennenelement 4 und einer Sende- und/oder Empfangseinheit 3. Gut zu erkennen sind in Fig. 5 die Durchkontaktierungen 29₁ bis 29ₙ. Wie bereits erläutert dienen diese Durchkontaktierungen 29₁ bis 29ₙ einerseits dazu, die Hornelemente 47 möglichst gut mit der Bezugsmasse zu kontaktieren, wohingegen sie gleichermaßen die Aufgabe erfüllen, eine Ausbreitung der von dem Antennenelement 4 abgestrahlten elektromagnetischen Welle innerhalb der Leiterplattenanordnung 1 zu vermeiden. Dargestellt ist ebenfalls, dass mehrere dieser Durchkontaktierungen 29₁ bis 29ₙ radial um die Patch-Antenne 41 herum angeordnet sind und dass diese den ersten Teil 20 der Leiterplattenanordnung 1 bis zu der geschlossenen dicken Massefläche 22₂ durchdringen. In dem Ausführungsbeispiel aus Fig. 5 ist die obere Schicht 21₁ der ersten Leiterplatte 21 in weiten Teilen weggeätzt oder weggefräst. Es ist aber durchaus möglich, dass die obere Schicht 21₁ der ersten Leiterplatte 21 mit Ausnahme eines Bereichs um die Patch-Antenne 41 und der Sende- und/oder Empfangseinheit 3 herum vollständig das Substrat 21₃ bedeckt.

Zu erkennen ist ebenfalls der ausgefräste und/oder ausgestanzte Hohlraum 45, in den die Sende- und/oder Empfangseinheit 3 integriert ist. Sichtbar ist ebenfalls, dass die Sende- und/oder Empfangseinheit 3 in Form eines Sende- und/oder Empfangschips 3 realisiert ist und auf die dicke Massefläche 22₂ aufgesetzt bzw. fest mit dieser verklebt ist. In der Draufsicht aus Fig. 5 ist die dicke Massefläche 22₂ außerdem von dem Substrat 22₃ der zweiten Leiterplatte 22 des ersten Teils 20 der Leiterplattenanordnung 1 umgeben. Es ist gut zu erkennen, dass sich auf dem zweiten Substrat 22₃ die koplanare Zweibandleitung 43 befindet, die zur Anregung der Patchantenne 41 dient. Weiterhin befinden sich auf diesem Substrat 22₃ weitere Leiterbahnen, die zur Spannungsversorgung oder Ansteuerung der Sende- und/oder Empfangseinheit 3 dienen, oder über die das Zwischenfrequenzsignal an die Messelektronik 10 übergeben wird. Gut zu erkennen ist auf der rechten Seite ebenfalls noch eine Leiterbahn 54, über die beispielsweise ein von außen zugeführtes Hochfrequenzsignal an die Sende- und/oder Empfangseinheit 3 weitergeleitet wird.

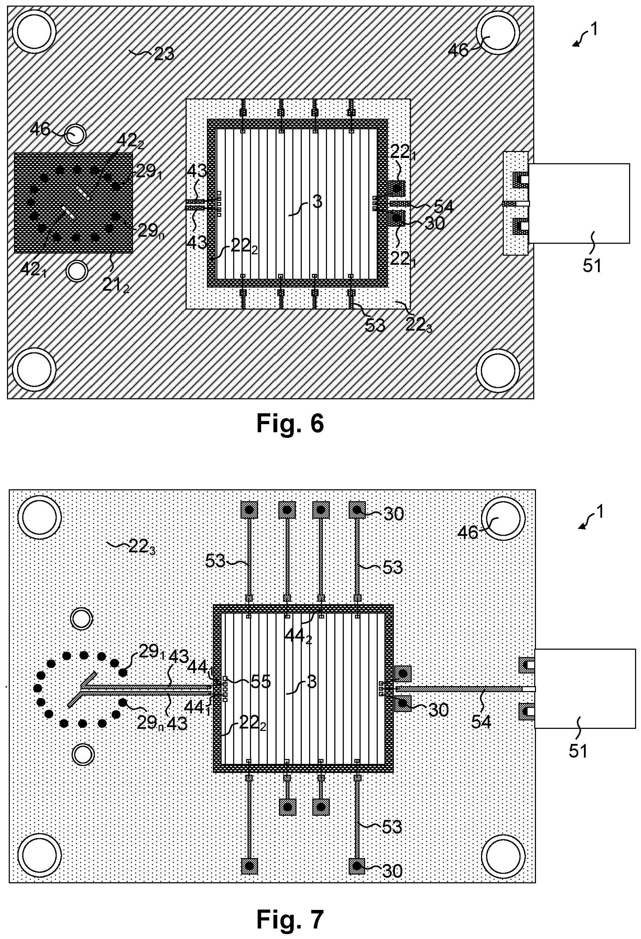

Fig. 6 zeigt ein Ausführungsbeispiel einer Draufsicht auf die untere Schicht 21₂ einer ersten Leiterplatte 21 innerhalb des ersten Teils 20 der erfindungsgemäßen Leiterplattenanordnung 1. Gut zu erkennen ist die Klebeverbindung 23, die zum mechanisch stabilen Verbinden der beiden Leiterplatten 21 und 22 im ersten Teil 20 der Leiterplattenanordnung 1 dient. Die aus Kupfer bestehende untere Schicht 21₂ der ersten Leiterplatte 21 ist nur in einem kleinen Bereich ausgebildet, wenngleich dies auch auf der gesamten Schicht der Klebeverbindung 23 möglich wäre. Innerhalb dieser unteren Schicht 21₂ sind in diesem Ausführungsbeispiel beispielsweise zwei rechteckförmige Schlitze 42₁, 42₂ ausgebildet. Diese beiden schlitzförmigen Ausnehmungen in der unteren Kupferschicht 21₂ ermöglichen in der Draufsicht den Blick auf die darunterliegende Klebeschicht 23. Zu erkennen sind ebenfalls die Durchkontaktierungen 29₁ bis 29ₙ. Wie auch schon in Fig. 5 ist auch in Fig. 6 die Sende- und/oder Empfangseinheit 3 mit den entsprechenden Anschlussleitungen, beispielsweise der koplanaren Zweibandleitung 43 dargestellt. Gut zu erkennen ist auch hier wieder die dicke Massefläche 22₂, die gleichzeitig die untere Schicht 22₂ der zweiten Leiterplatte 22 des ersten Teils 20 der Leiterplattenanordnung 1 bildet.

Fig. 7 zeigt ein Ausführungsbeispiel einer Draufsicht auf die obere Schicht 22₁ der zweiten Leiterplatte 22 innerhalb des ersten Teils 20 der erfindungsgemäßen Leiterplattenanordnung 1. Gut zu erkennen sind die vergoldete koplanare Zweibandleitung 43, deren Ende in einen Dipol übergeht, und das darunterliegende Substrat 22₃. Ebenfalls sichtbar sind die Durchkontaktierungen 29₁ bis 29ₙ, wobei es besonders vorteilhaft ist, dass keine Durchkontaktierung im Bereich der Zuführung der koplanaren Zweibandleitung 43 vorhanden ist. Die unter dem Substrat 22₃ befindliche dicke Massefläche 22₂, die auch die untere Schicht 22₂ der zweiten Leiterplatte 22 bildet, sorgt dafür, dass das durch den Dipol der koplanaren Zweibandleitung 43 ausgesendete elektromagnetische Feld in Richtung der Patchantenne 41 reflektiert wird. Wie bereits erläutert dienen die Durchkontaktierungen 29₁ bis 29ₙ dazu, um sicherzustellen, dass sich das elektromagnetische Feld nicht innerhalb der Leiterplattenanordnung 1 ausbreitet und so zu Messfehlern führt.

Gut sichtbar sind außerdem die Leiterbahnen 53, die elektrisch mit den Durchkontaktierungen 30 verbunden sind und die Sende- und/oder Empfangseinheit 3 mit dem zweiten Teil 24 der Leiterplattenanordnung 1 verbinden. Ebenfalls ist sehr gut die Leiterbahn 54 zu sehen, die die Sende- und/oder Empfangseinheit 3 mit dem Koaxialstecker 51 verbindet. Über den Koaxialstecker 51 kann, wie bereits erläutert, von außen ein Hochfrequenzsignal zugeführt werden, welches innerhalb der Sende- und/oder Empfangseinheit 3 auf die gewünschte Frequenz hochgemischt wird. Die Sende- und/oder Empfangseinheit 3 ist, um einen günstigen Wärmeübergangswiderstand zu erreichen, auf die dicke Massefläche 22₂ geklebt. Die Sende- und/oder Empfangseinheit 3 verfügt weiterhin über vergoldete Anschlusskontakte 55, die wiederum über die Bonddrähte 44₁, 44₂ mit den entsprechenden Leiterbahnen auf der oberen Schicht 22₁ der zweiten Leiterplatte 22 des ersten Teils 20 der Leiterplattenanordnung 1 elektrisch verbunden werden.

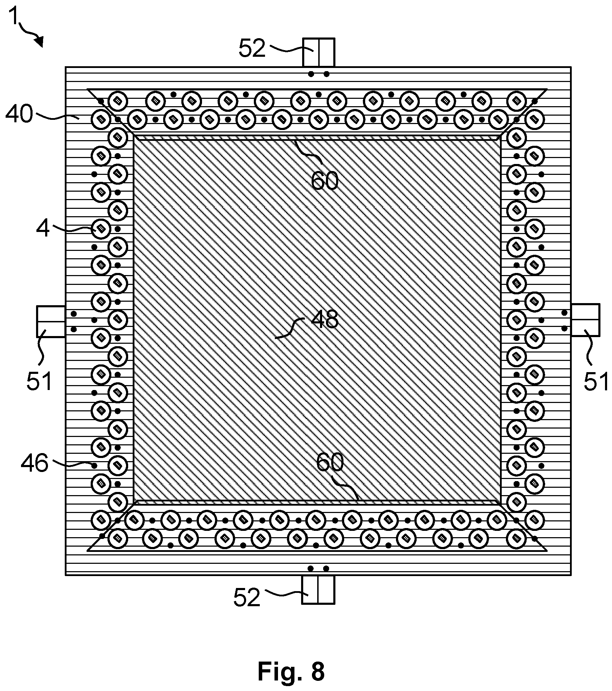

Fig. 8 zeigt ein weiteres Ausführungsbeispiel einer Draufsicht auf die erfindungsgemäße Leiterplattenanordnung 1 mit einem Deckel 40 und einer Vielzahl an Antennenelementen 4. In dem Ausführungsbeispiel aus Fig. 8 ist in der Fläche zwischen den Antennenelementen 4 die Dämpfungsmatte 48 ausgebildet. Zu erkennen ist ein massiver Deckel 40, in den 92 Hornelemente 47 gebohrt, bzw. gefräst und/oder geätzt sind. Diese Vielzahl an Antennenelementen 4 sind dabei auf der Leiterplattenanordnung 1 in einem Quadrat angeordnet. Dabei ist bevorzugt jedes Antennenelement 4 entweder mit einer Sendeeinheit oder mit einer Empfangseinheit verbunden.

Beispielsweise können jeweils vier Antennenelemente 4, die in dem Bereich 60 angeordnet sind, mit je einer Sendeeinheit verbunden werden, wohingegen ebenfalls zum Beispiel jeweils vier Antennenelemente 4, die nicht in dem Bereich 60 liegen, mit je einer Empfangseinheit verbunden werden. Die Steuereinheit 9 kann dabei festlegen, dass zu jedem Zeitpunkt nur ein mit einer Sendeeinheit verbundenes Antennenelement 4 eine elektromagnetische Welle aussendet und dass gleichzeitig die elektromagnetische Welle, die von den Antennenelementen 4 empfangen wird, die mit einer Empfangseinheit verbunden sind, durch die Messelektronik 10 ausgewertet wird. Im nächsten Schritt wird derselbe Vorgang für ein anderes Antennenelement 4, welches ebenfalls mit einer Sendeeinheit verbunden ist, wiederholt. Hierfür sind bevorzugt alle Patchantennen 41 in der gleichen Richtung ausgerichtet.

Besonders vorteilhaft ist, dass mehrere der in Fig. 8 gezeigten Leiterplattenanordnungen 1 mit zumindest je einem Antennenelement 4 zusammen als Array (Antennengruppe) betrieben werden können. Dabei sendet genau ein Antennenelement 4 des gesamten Arrays ein Signal zu einer bestimmten Zeit aus, wobei alle anderen Antennenelemente 4 des gesamten Arrays, die mit einer Empfangseinheit verbunden sind, gegebenenfalls eine Reflektion dieses Signals empfangen, welches im Anschluss daran durch die Messelektronik 10 ausgewertet wird. Durch dieses besonders vorteilhafte Zusammenschalten von mehreren Leiterplattenanordnungen 1 kann ein großer räumlicher Bereich untersucht werden, ohne dass die räumliche Position der Leiterplattenanordnung 1 geändert werden müsste.

Die über die Koaxialstecker 51,52 zugeführten Hochfrequenz-Signale können beispielsweise über Wilkinson-Teiler aufgeteilt und an verschiedene Sende- und Empfangseinheiten weitergeleitet werden. Im Rahmen der Erfindung sind alle beschriebenen und/oder gezeichneten Merkmale beliebig miteinander kombinierbar.

## Patentansprüche

1. Leiterplattenanordnung (1) zum elektrischen Verbinden zumindest einer Sende- und/oder Empfangseinheit (3) mit zumindest einem Antennenelement (4), wobei die zumindest eine Sende- und/oder Empfangseinheit (3) und das zumindest eine Antennenelement (4) zumindest teilweise in die Leiterplattenanordnung (1) integriert sind,
wobei die Leiterplattenanordnung (1) aus verschiedenen Leiterplatten (21,22,25,26) besteht, die mechanisch fest miteinander verbunden sind, wobei ein erster Teil (20) der Leiterplattenanordnung (1) durch zumindest eine Leiterplatte (21,22) gebildet ist, deren Substrat (21₃,22₃) aus einem ersten Material besteht, das für Hochfrequenz geeignet ist, und ein zweiter Teil (24) der Leiterplattenanordnung (1) durch zumindest eine Leiterplatte (25,26) gebildet ist, deren Substrat aus einem gegenüber dem ersten Material unterschiedlichen zweiten Material besteht, welches nur für eine Niederfrequenz und/oder für einen Gleichspannungsbereich geeignet ist,
wobei beide Teile (20,24) der Leiterplattenanordnung (1) durch eine Massefläche (22₂) voneinander getrennt sind und,
wobei aufgrund der dicken Massefläche (22₂) der hochfrequente Teil, der dem ersten Teil (20) der Leiterplattenanordnung (1) zugeordnet ist, von dem niederfrequenten Teil, der dem zweiten Teil (24) der Leiterplattenanordnung (1) zugeordnet ist, vollständig getrennt ist,
wobei die Sende- und/oder Empfangseinheit (3) zur besseren Wärmeabfuhr direkt auf der Massefläche (22₂) angeordnet ist,
wobei das zumindest eine Antennenelement (4) innerhalb eines Käfigs angeordnet ist,
wobei der Käfig sich aus der Massefläche (22₂) sowie mehreren Durchkontaktierungen (29; 29₁, 29ₙ) zusammensetzt und sich an einem leitfähigen Deckel fortsetzt,
wobei die Durchkontaktierungen (29, 29₁, 29ₙ) radial um das Antennenelement (41) herum angeordnet sind, und den ersten Teil (20) der Leiterplattenanordnung (1) bis zu der Massefläche (22₂) durchdringen, und
wobei das zumindest eine Antennenelement (4) eine Patchantenne (41) aufweist, die über eine mit der Sende- und/oder Empfangseinheit (3) verbundene Zweibandleitung (43) anregbar ist.

2. Leiterplattenanordnung nach Anspruch 1,
**dadurch gekennzeichnet,**
**dass** das zumindest eine Antennenelement (4) und die zumindest eine Sende- und/oder Empfangseinheit (3) in dem ersten Teil (20) der Leiterplattenanordnung (1) ausgebildet sind.

3. Leiterplattenanordnung nach einem der vorherigen Ansprüche,
**dadurch gekennzeichnet,**
**dass** zumindest ein Hohlraum (45) in den ersten Teil (20) der Leiterplattenanordnung (1) gefräst und/oder gestanzt ist, in dem die Sende- und/oder Empfangseinheit (3) integriert ist.

4. Leiterplattenanordnung nach einem der vorherigen Ansprüche,
**dadurch gekennzeichnet,**
**dass** die Leiterplattenanordnung einen elektrisch leitfähigen Deckel (40) beinhaltet,
**dass** über dem zumindest einen Antennenelement (4) weiterhin ein Hornelement (47) angeordnet ist, das in den elektrisch leitfähigen Deckel (40) eingebracht, insbesondere gebohrt und/oder gefräst und/oder geätzt ist, und dass dieser elektrisch leitfähige Deckel (40) fest mit der Leiterplattenanordnung (1) verschraubt und/oder verklebt ist.

5. Leiterplattenanordnung nach Anspruch 4,
**dadurch gekennzeichnet,**
**dass** der elektrisch leitfähige Deckel (40) eine gesamte Oberfläche des ersten Teils (20) der Leiterplattenanordnung (1) mit Ausnahme des zumindest einen Antennenelements (4) bedeckt.

6. Leiterplattenanordnung nach Anspruch 3 und einem der Ansprüche 4 oder 5,
**dadurch gekennzeichnet,**
**dass** mit Ausnahme der Ausnehmung für das Hornelement (47) eine Oberseite des elektrisch leitfähigen Deckels (40) mit einer Dämpfungsmatte (48) bedeckt ist und/oder
**dass** eine Unterseite des elektrisch leitfähigen Deckels (40) oberhalb des Hohlraums (45) des ersten Teils (20) der Leiterplattenanordnung (1) mit einer Dämpfungsmatte (48) bedeckt ist.

7. Leiterplattenanordnung nach einem der vorherigen Ansprüche,
**dadurch gekennzeichnet,**
**dass** die Zweibandleitung (43) koplanar ist.

8. Leiterplattenanordnung nach einem der vorherigen Anprüche,
**dadurch gekennzeichnet,**
**dass** zwischen der Patchantenne (41) und der Zweibandleitung (43) eine Massefläche (21₂) ausgebildet ist, in der zumindest ein Schlitz (42, 42₁,42₂) integriert ist.

9. Leiterplattenanordnung nach einem der vorherigen Ansprüche,
**dadurch gekennzeichnet,**
**dass** keine Durchkontaktierung im Bereich der Zuführung der Zweibandleitung (43) vorhanden ist.

10. Leiterplattenanordnung nach einem der vorherigen Ansprüche,
**dadurch gekennzeichnet,**
**dass** der Niederfrequenzbereich und/oder der Gleichspannungsbereich der
Sende- und/oder Empfangseinheit (3) über Durchkontaktierungen (30) mit der zumindest einen Leiterplatte (25,26) des zweiten Teils (24) der Leiterplattenanordnung (1) verbunden ist.

11. Leiterplattenanordnung nach einem der vorherigen Ansprüche,
**dadurch gekennzeichnet,**
**dass** es sich bei der Sende- und/oder Empfangseinheit (3) um einen Sende- und/oder Empfangschip (3) handelt, dessen Anschlusskontakte (55) mit der zumindest einen Leiterplatte (21,22) des ersten Teils (20) der Leiterplattenanordnung (1) insbesondere über Bonddrähte (44₁,44₂) verbunden sind.

12. Leiterplattenanordnung nach einem der vorherigen Ansprüche,
**dadurch gekennzeichnet,**
**dass** an einer Unterseite der Leiterplattenanordnung (1) eine Steckverbindung angeordnet ist, über die die zumindest eine Sende- und/oder Empfangseinheit (3) mit einer Steuereinheit (9) und/oder einer Messelektronik (10) verbunden ist.

13. Leiterplattenanordnung nach einem der vorherigen Ansprüche,
**dadurch gekennzeichnet,**
**dass** die Sende- und/oder Empfangseinheit (3) mit mehreren Antennenelementen (4) verbunden ist und/oder
**dass** eine Vielzahl von Antennenelementen (4) auf der Leiterplattenanordnung (1) in einem Quadrat angeordnet sind.

14. Leiterplattenanordnung nach Anspruch 13,
**dadurch gekennzeichnet,**
**dass** jedes Antennenelement (4) entweder mit einer Sendeeinheit oder mit einer Empfangseinheit verbunden ist und dass zu einem bestimmten Zeitpunkt nur über ein bestimmtes mit einer Sendeeinheit verbundenes Antennenelement (4) ein Signal aussendbar ist.

15. Millimeterwellen-Scanner mit mehreren Leiterplattenanordnungen nach einem der vorherigen Ansprüche,
**dadurch gekennzeichnet,**
**dass** die Leiterplattenanordnungen (1) mit zumindest je einem Antennenelement (4) zusammen ein Array bilden, wobei von genau einem Antennenelement (1) des gesamten Arrays ein Signal aussendbar ist und wobei für alle anderen Antennenelemente (1) des gesamten Arrays, die mit einer Empfangseinheit verbunden sind, eine Reflexion dieses Signals empfangbar ist.

## Claims

1. Printed circuit board arrangement (1) for electrical connection of at least one transmitting and/or receiving unit (3) with at least one antenna element (4), wherein the at least one transmitting and/or receiving unit (3) and the at least one antenna element (4) are at least partly integrated in the printed circuit board arrangement (1),
wherein the printed circuit board arrangement (1) is composed of different printed circuit boards (21, 22, 25, 26) which are connected securely with one another mechanically, wherein a first part (20) of the printed circuit board arrangement (1) is formed by at least one printed circuit board (21, 22) the substrate (21₃, 22₃) of which is composed of a first material which is suitable for high frequency, and a second part (24) of the printed circuit board arrangement (1) is formed by at least one printed circuit board (25, 26) the substrate of which is composed of a second material which is different to the first material and is only suitable for a low frequency and/or for a direct current voltage region, wherein the two parts (20, 24) of the printed circuit board arrangement (1) are separated from one another by a ground plane (22₂) and
wherein due to the thick ground plane (22₂) the high frequency part which is associated with the first part (20) of the printed circuit board arrangement (1) is completely separated from the low frequency part which is associated with the second part (24) of the printed circuit board arrangement (1),
wherein the transmitting and/or receiving unit (3) is arranged directly on the ground plane (22₂) for better heat dissipation,
wherein the at least one antenna element (4) is arranged inside a cage,
wherein the cage is composed of the ground plane (22₂) and a plurality of vias (29; 29₁, 29ₙ) and continues on a conductive cover,
wherein the vias (29, 29₁, 29ₙ) are arranged radially around the antenna element (41) and pass through the first part (20) of the printed circuit board arrangement (1) to the ground plane (22₂), and
wherein the at least one antenna element (4) has a patch antenna (41) which can be excited through a two-strip line (43) connected with the transmitting and/or receiving unit (3).

2. Printed circuit board arrangement according to claim 1,
**characterised in that**
the at least one antenna element (4) and the at least one transmitting and/or receiving unit (3) are formed in the first part (20) of the printed circuit board arrangement (1).

3. Printed circuit board arrangement according to one of the preceding claims,
**characterised in that**
milled and/or stamped in the first part (20) of the printed circuit board arrangement (1) there is at least one cavity (45) in which the transmitting and/or receiving unit (3) is integrated.

4. Printed circuit board arrangement according to one of the preceding claims,
**characterised in that**
the printed circuit board arrangement comprises an electrically conductive cover (40),
**in that** arranged over the at least one antenna element (4) there is also a horn element (47) which is formed, in particular bored and/or milled and/or etched, in the electrically conductive cover (40), and
**in that** this electrically conductive cover (40) is screwed and/or glued securely to the printed circuit board arrangement (1).

5. Printed circuit board arrangement according to claim 4,
**characterised in that**
the electrically conductive cover (40) covers one entire surface of the first part (20) of the printed circuit board arrangement (1) with the exception of the at least one antenna element (4).

6. Printed circuit board arrangement according to claim 3 and one of claims 4 or 5,
**characterised in that**
with the exception of the recess for the horn element (47) one upper side of the electrically conductive cover (40) is covered with an attenuating mat (48) and/or
**in that** one underside of the electrically conductive cover (40) above the cavity (45) of the first part (20) of the printed circuit board arrangement (1) is covered with an attenuating mat (48).

7. Printed circuit board arrangement according to one of the preceding claims,
**characterised in that**
the two-strip line (43) is coplanar.

8. Printed circuit board arrangement according to one of the preceding claims,
**characterised in that**
formed between the patch antenna (41) and the two-strip line (43) there is a ground plane (21₂) in which at least one slot (42, 42₁, 42₂) is integrated.

9. Printed circuit board arrangement according to one of the preceding claims,
**characterised in that**
there is no via in the area of the lead-in of the two-strip line (43).

10. Printed circuit board arrangement according to one of the preceding claims,
**characterised in that**
the low frequency region and/or the direct current voltage region of the transmitting and/or receiving unit (3) is connected with the at least one printed circuit board (25, 26) of the second part (24) of the printed circuit board arrangement (1) by means of vias (30).

11. Printed circuit board arrangement according to one of the preceding claims,
**characterised in that**
the transmitting and/or receiving unit (3) is a transmitting and/or receiving chip (3) the connecting contacts (55) of which are connected with the at least one printed circuit board (21, 22) of the first part (20) of the printed circuit board arrangement (1) in particular by means of bonding wires (44₁, 44₂).

12. Printed circuit board arrangement according to one of the preceding claims,
**characterised in that**
arranged on one underside of the printed circuit board arrangement (1) there is a plug connection by means of which the at least one transmitting and/or receiving unit (3) is connected with a control unit (9) and/or an electronic measuring unit (10).

13. Printed circuit board arrangement according to one of the preceding claims,
**characterised in that**
the transmitting and/or receiving unit (3) is connected with a plurality of antenna elements (4) and/or
**in that** a multiplicity of antenna elements (4) are arranged on the printed circuit board arrangement (1) in a square.

14. Printed circuit board arrangement according to claim 13,
**characterised in that**
each antenna element (4) is connected either with a transmitting unit or with a receiving unit and
**in that** a signal can only be sent out by means of a specific antenna element (4) connected with a transmitting unit at a specific point in time.

15. Millimetre wave scanner with a plurality of printed circuit board arrangements according to one of the preceding claims,
**characterised in that**
the printed circuit board arrangements (1) each with at least one antenna element (4) together form an array, wherein a signal can be sent out by just one antenna element (1) of the entire array and wherein a reflection of this signal can be received for all the other antenna elements (1) of the entire array which are connected with a receiving unit.

## Revendications

1. Agencement de circuits imprimés (1) pour la connexion électrique d'au moins une unité émettrice et/ou réceptrice (3) à au moins un élément d'antenne (4), où ladite au moins une unité émettrice et/ou réceptrice (3) et ledit au moins un élément d'antenne (4) sont au moins partiellement intégrés dans l'agencement de circuits imprimés (1),
où l'agencement de circuits imprimés (1) se compose de différents circuits imprimés (21, 22, 25, 26), fixement raccordés mécaniquement les uns aux autres, une première partie (20) de l'agencement de circuits imprimés (1) étant formée par au moins un circuit imprimé (21, 22) dont le substrat (21₃, 22₃) est constitué d'un premier matériau adapté pour des hautes fréquences, et une deuxième partie (24) de l'agencement de circuits imprimés (1) étant formée par au moins un circuit imprimé (25, 26) dont le substrat est constitué d'un deuxième matériau différent du premier matériau, lequel n'est adapté que pour des basses fréquences et/ou pour une plage de tension continue,
où les deux parties (20, 24) de l'agencement de circuits imprimés (1) sont séparées l'une de l'autre par un plan de masse (22₂), et
où, en raison de l'épaisseur du plan de masse (22₂), la partie hautes fréquences associée à la première partie (20) de l'agencement de circuits imprimés (1) est entièrement séparée de la partie basses fréquences associée à la deuxième partie (24) de l'agencement de circuits imprimés (1),
où l'unité émettrice et/ou réceptrice (3) est disposée directement sur le plan de masse (22₂) pour une meilleure dissipation de chaleur,
où ledit au moins un élément d'antenne (4) est disposé à l'intérieur d'une cage,
où la cage se compose du plan de masse (22₂) et de plusieurs trous de passage (29 ; 29₁, 29ₙ) et se prolonge sur un couvercle conducteur,
où les trous de passage (29, 29₁, 29ₙ) sont disposés radialement tout autour de l'élément d'antenne (41), et traversent la première partie (20) de l'agencement de circuits imprimés (1) jusqu'au plan de masse (22₂), et
où ledit au moins un élément d'antenne (4) comporte une antenne patch (41) excitable au moyen d'une ligne à deux bandes (43) reliée à l'unité émettrice et/ou réceptrice (3).

2. Agencement de circuits imprimés selon la revendication 1,
**caractérisé en ce que**
ledit au moins un élément d'antenne (4) et ladite au moins une unité émettrice et/ou réceptrice (3) sont prévus dans la première partie (20) de l'agencement de circuits imprimés (1).

3. Agencement de circuits imprimés selon l'une des revendications précédentes,
**caractérisé en ce que**
au moins une cavité (45) où est intégrée l'unité émettrice et/ou réceptrice (3) est fraisée et/ou découpée dans la première partie (20) de l'agencement de circuits imprimés (1).

4. Agencement de circuits imprimés selon l'une des revendications précédentes,
**caractérisé en ce que**
ledit agencement de circuits imprimés comprend un couvercle (40) électriquement conducteur,
**en ce qu'**un élément en cornet (47) est en outre disposé au-dessus dudit au moins un élément d'antenne (4), lequel est ménagé dans le couvercle (40) électriquement conducteur, en particulier foré et/ou fraisé et/ou gravé, et **en ce que** ledit couvercle (40) électriquement conducteur est fixement vissé et/ou collé avec l'agencement de circuits imprimés (1).

5. Agencement de circuits imprimés selon la revendication 4,
**caractérisé en ce que**
le couvercle (40) électriquement conducteur couvre toute la surface de la première partie (20) de l'agencement de circuits imprimés (1), à l'exception dudit au moins un élément d'antenne (4).

6. Agencement de circuits imprimés selon la revendication 3 et selon la revendication 4 ou la revendication 5,
**caractérisé en ce que**
à l'exception de l'évidement pour l'élément en cornet (47), une face supérieure du couvercle (40) électriquement conducteur est recouverte d'un treillis amortisseur (48), et/ou
**en ce qu'**une face inférieure du couvercle (40) électriquement conducteur est recouverte d'un treillis amortisseur (48) au-dessus de la cavité (45) de la première partie (20) de l'agencement de circuits imprimés (1).

7. Agencement de circuits imprimés selon l'une des revendications précédentes,
**caractérisé en ce que**
la ligne à deux bandes (43) est coplanaire.

8. Agencement de circuits imprimés selon l'une des revendications précédentes,
**caractérisé en ce que**
un plan de masse (21₂) où au moins une fente (42, 42₁, 42₂) est intégrée est formé entre l'antenne patch (41) et la ligne à deux bandes (43).

9. Agencement de circuits imprimés selon l'une des revendications précédentes,
**caractérisé en ce que**
aucun trou de passage n'est présenté au niveau de l'arrivée de la ligne à deux bandes (43).

10. Agencement de circuits imprimés selon l'une des revendications précédentes,
**caractérisé en ce que**
la zone basses fréquences et/ou la zone de tension continue de l'unité émettrice et/ou réceptrice (3) sont reliées par des trous de passage (30) avec ledit au moins un circuit imprimé (25, 26) de la deuxième partie (24) de l'agencement de circuits imprimés (1).

11. Agencement de circuits imprimés selon l'une des revendications précédentes,
**caractérisé en ce que**
l'unité émettrice et/ou réceptrice (3) est une puce émettrice et/ou réceptrice (3) dont les contacts de connexion (55) sont reliés audit au moins un circuit imprimé (21, 22) de la première partie (20) de l'agencement de circuits imprimés (1), en particulier par des fils de connexion (44₁, 44₂).

12. Agencement de circuits imprimés selon l'une des revendications précédentes,
**caractérisé en ce que**
une connexion par fiche est disposée sur une face inférieure de l'agencement de circuits imprimés (1), au moyen de laquelle ladite au moins une unité émettrice et/ou réceptrice (3) est reliée à une unité de commande (9) et/ou à une électronique de mesure (10).

13. Agencement de circuits imprimés selon l'une des revendications précédentes,
**caractérisé en ce que**
l'unité émettrice et/ou réceptrice (3) est reliée à plusieurs éléments d'antenne (4), et/ou
**en ce qu'**une pluralité d'éléments d'antenne (4) sont disposés en carré sur l'agencement de circuits imprimés (1).

14. Agencement de circuits imprimés selon la revendication 13,
**caractérisé en ce que**
chaque élément d'antenne (4) est relié soit à une unité émettrice, soit à une unité réceptrice, et **en ce qu'**un signal peut être émis à un moment déterminé, exclusivement par un élément d'antenne (4) déterminé relié à une unité émettrice.

15. Scanner à ondes millimétriques avec plusieurs dispositifs de circuit imprimé selon l'une des revendications précédentes,
**caractérisé en ce que**
les dispositifs de circuit imprimé (1) forment un réseau avec au moins un élément d'antenne (4) chacun, qu'un signal pouvant être émis par un élément d'antenne (1) précis de l'ensemble du réseau, et une réflexion de ce signal pouvant être reçue pour tous les autres éléments d'antenne (1) de l'ensemble du réseau reliés à une unité réceptrice.
